# EUROPEAN PATENT APPLICATION

(11) **EP 4 835 501 A1**
(43) Date of publication of application: **04.11.2026**
(21) Application number: 25877605.3
(22) Date of filing: 30.09.2025
(51) Int. Cl.: G01R 31/385, G01R 31/396, G01R 19/10, G01R 19/165, G01R 35/00, G01R 27/02, H02J 7/00

(54) **BATTERY CELL VOLTAGE MEASUREMENT METHOD AND BATTERY SYSTEM**

(30) Priority: 08.10.2024 KR 20240136643
(71) Applicant: LG Energy Solution, Ltd., Seoul 07335 (KR)
(72) Inventor: HEO, Sungjun, Daejeon 34122 (KR)
(74) Representative: Plasseraud IP
(86) International application number: PCT/KR2025/015555
(87) International publication number: WO 2026/079795

(57) **Abstract**

A battery system according to an embodiment of the present disclosure includes a plurality of battery cells electrically connected, a BMIC including a terminal through which a cell balancing current for cell balancing flows and connected to both ends of each of the plurality of battery cells to measure each of the plurality of cell voltages during each cell voltage measurement cycle when the cell balancing is performed on the plurality of battery cells, and an MCU determining whether to end the cell balancing based on the cell voltage of a first battery cell during the current cell voltage measurement cycle and each of the plurality of cell voltages of each of the remaining plurality of battery cells when the difference between the cell voltage of the first battery cell including the positive electrode connected to the terminal during the current cell voltage measurement cycle and the cell voltage during the previous cell voltage measurement cycle among the plurality of cell voltages is greater than or equal to a predetermined correction value.

## Description

### [Background Art]

### CROSS-REFERENCE TO RELATED APPLICATION

This application claims priority to and the benefit of Korean Patent Application No. 10-2024-0136643 filed at the Korean Intellectual Property Office on October 8, 2024, the entire contents of which are incorporated herein by reference.

The present disclosure relates to a method for accurately measuring cell voltage of a plurality of battery cells included in a battery and a battery management system.

### [Background Art]

Batteries are an eco-friendly technology that plays a key role in various fields such as electric vehicles and renewable energy storage. Batteries are a vital tool for reducing carbon emissions and enabling cleaner, more sustainable energy use by replacing existing energy systems that rely on fossil fuels. Particularly, the importance of battery technology is increasing day by day with the growth of electric vehicles and energy storage systems (ESS).

Cell balancing is essential for efficient and safe battery use. In a battery system, multiple battery cells are connected to form a pack, and an imbalance between the battery cells may lead to performance degradation, shortened lifespan, and even safety issues. Cell balancing minimizes differences in voltage and capacity between individual battery cells to ensure uniform operation, which is critical to maintaining the performance and safety of the battery pack.

Accurate cell balancing requires technology to measure the voltage of battery cells very accurately. Even small voltage differences between battery cells may lead to large imbalances in the long run.

### [Disclosure]

### [Technical Problem]

The present disclosure attempts to provide a method for accurately measuring cell voltage of a plurality of battery cells included in a battery and a battery management system.

### [Technical Solution]

A battery system according to an embodiment of the present disclosure includes a plurality of electrically connected battery cells, including a terminal through which a cell balancing current for cell balancing flows and a battery monitoring IC (BMIC) connected to both ends during each of the plurality of battery cells to measure each of the plurality of cell voltages during each cell voltage measurement cycle when the cell balancing is performed on the plurality of battery cells, and an micro control unit (MCU) determining whether to end the cell balancing based on the cell voltage of a first battery cell during the current cell voltage measurement cycle and each of the plurality of cell voltages of each of the remaining plurality of battery cells when the difference between the cell voltage of the first battery cell including the positive electrode connected to the terminal during the current cell voltage measurement cycle and the cell voltage during the previous cell voltage measurement cycle among the plurality of cell voltages is greater than or equal to a predetermined correction value.

The correction value may be calculated by multiplying the number of battery cells among the plurality of battery cells on which the cell balancing is being performed, the size of the resistance connected between the terminal and the first battery cell, and the amount of current consumed by the first battery cell when the cell balancing is performed for one battery cell.

The MCU may include a cell voltage corrector receiving each of the plurality of cell voltages from the BMIC during each cell voltage measurement cycle and determining whether correction is required for the cell voltage of the first battery cell based on a change in the magnitude of the cell voltage of the first battery cell, and a cell balancing controller generating a control signal for ending the cell balancing and transmitting the control signal to the BMIC based on a determination of whether to end the cell balancing.

When the difference between the cell voltage during the current cell voltage measurement cycle and the cell voltage during the previous cell voltage measurement cycle of the first battery cell is less than the correction value, the MCU may add the correction value to the cell voltage of the first battery cell during the current cell voltage measurement cycle to generate a first cell voltage of the first battery cell, and determine whether to end the cell balancing based on the first cell voltage and each of the plurality of cell voltages of each of the remaining plurality of battery cells.

When the difference between the cell voltage of the first battery cell during the previous cell voltage measurement cycle and the cell voltage during the current cell voltage measurement cycle is greater than or equal to the correction value, the MCU may add the correction value to the cell voltage of the first battery cell during the current cell voltage measurement cycle to generate the first cell voltage of the first battery cell, and determine whether to end the cell balancing based on the first cell voltage and each of the plurality of cell voltages of each of the remaining plurality of battery cells.

When the difference between the cell voltage of the first battery cell during the previous cell voltage measurement cycle and the cell voltage during the current cell voltage measurement cycle is less than the correction value, the MCU may determine whether to end the cell balancing based on the cell voltage of the first battery cell during the current cell voltage measurement cycle and each of the plurality of cell voltages of each of the remaining plurality of battery cells.

A method for measuring battery cell voltage according to an embodiment of the present disclosure includes a BMIC performing cell balancing on at least one battery cell among a plurality of battery cells included in a battery, the BMIC measuring each of a plurality of cell voltages of each of the plurality of battery cells while the cell balancing is performed, an MCU correcting the cell voltage of a first battery cell by adding a predetermined correction value to the cell voltage of the first battery cell, which includes a positive electrode connected to a terminal through which a cell balancing current flows in the BMIC, among the plurality of cell voltages received from the BMIC, and the MCU determining whether to end the cell balancing based on the cell voltage of the first battery cell that has been corrected and each of the plurality of cell voltages of the remaining plurality of battery cells.

When the difference between the cell voltage during the current cell voltage measurement cycle and the cell voltage during the previous cell voltage measurement cycle of the first battery cell is greater than or equal to the correction value, the correcting of the cell voltage of the first battery cell may include a cell voltage corrector of the MCU transmitting the cell voltage of the first battery cell during the current cell voltage measurement cycle and each of the cell voltages of each of the remaining plurality of battery cells to a cell balancing controller of the MCU, without correcting the cell voltage of the first battery cell during the current cell voltage measurement cycle, and when the difference between the cell voltage during the current cell voltage measurement cycle and the cell voltage during the previous cell voltage measurement cycle of the first battery cell is less than the correction value, generating a first cell voltage of the first battery cell by adding the correction value to the cell voltage of the first battery cell during the current cell voltage measurement cycle, and transmitting the first cell voltage and each of the plurality of cell voltages of the remaining plurality of battery cells to the cell balancing controller.

The transmitting of the cell voltage of the first battery cell during the current cell voltage measurement cycle and each of the plurality of cell voltages of each of the remaining battery cells to the cell balancing controller of the MCU may include, when the difference between the cell voltage during the previous cell voltage measurement cycle and the cell voltage during the current cell voltage measurement cycle of the first battery cell is greater than or equal to the correction value, the cell voltage corrector generating the first cell voltage of the first battery cell by adding the correction value to the cell voltage of the first battery cell during the current cell voltage measurement cycle, and transmitting the first cell voltage and each of the plurality of cell voltages of the remaining battery cells to the cell balancing controller, and when the difference between the cell voltage of the first battery cell during the previous cell voltage measurement cycle and the cell voltage during the current cell voltage measurement cycle is less than the correction value, transmitting the cell voltage of the first battery cell during the current cell voltage measurement cycle and each of the plurality of cell voltages of each of the remaining battery cells to a cell balancing controller of the MCU, without correcting the cell voltage of the first battery cell during the current cell voltage measurement cycle.

The determining whether to end the cell balancing may include, in the correcting of the cell voltage of the first battery cell, when the difference between the cell voltage during the current cell voltage measurement cycle and the cell voltage during the previous cell voltage measurement cycle of the first battery cell is greater than or equal to the correction value, determining whether to end the cell balancing based on the cell voltage of the first battery cell during the current cell voltage measurement cycle and each of the plurality of cell voltages of each of the remaining plurality of battery cells, and in the correcting of the cell voltage of the first battery cell, when the difference between the cell voltage during the current cell voltage measurement cycle and the cell voltage during the previous cell voltage measurement cycle of the first battery cell is less than the correction value, determining whether to end the cell balancing based on the first cell voltage and each of the plurality of cell voltages of each of the remaining plurality of battery cells.

### [Advantageous Effects]

According to an embodiment of the present disclosure, it is possible to accurately measure the cell voltage of each of a plurality of battery cells regardless of whether BMIC performs cell balancing, charge over voltage (COV) control, and charge under voltage (CUV) control.

Effects that may be obtained from the present disclosure are not limited to only those mentioned above, and other effects which are not described herein would be apparent to those skilled in the art from the following description.

### [Description of the Drawings]

FIG. 1 is a block diagram of a battery system according to an embodiment of the present disclosure.
FIG. 2 is a flowchart of a method for measuring battery cell voltage according to an embodiment of the present disclosure.
FIG. 3 is a flowchart of a step of correcting cell voltage of a first battery cell according to an embodiment of the present disclosure.

### [Mode for Invention]

When describing the embodiments disclosed in the present disclosure, if it is determined that a detailed description of a related known technology may obscure the gist of the embodiments disclosed in this specification, such a detailed description is omitted. The accompanying drawings are intended only to facilitate understanding of the exemplary embodiments disclosed in this specification, and it is to be understood that the technical ideas disclosed herein are not limited by the accompanying drawings and include all modifications, equivalents, or substitutions that are within the range of the ideas and technology of the present disclosure.

Although the terms "first," "second," and the like are used to explain various components, the components are not limited to such terms. These terms are only used to distinguish one component from another component.

It is to be understood that when one component is referred to as being "connected" or "coupled" to another component, it may be connected or coupled directly to another component or there may be other intervening components. On the other hand, it is to be understood that when one component is referred to as being "directly connected" or "directly coupled" to another component, there are no other intervening components.

Throughout the specification, the terms "comprise" and "have" are intended to specify the presence of stated features, integers, steps, operations, components, or a combination thereof, but do not preclude the presence or addition of one or more other features, integers, steps, operations, components, or combinations thereof.

Hereinafter, the present disclosure is described in detail with reference to the attached drawings.

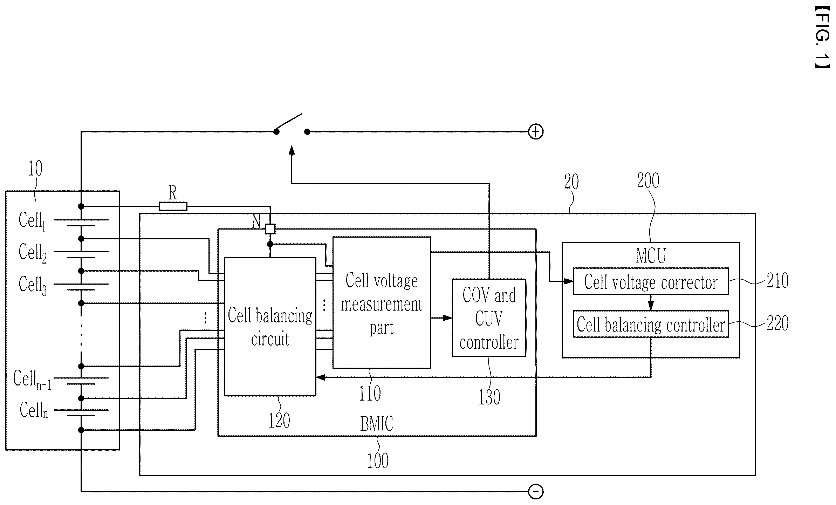

FIG. 1 is a block diagram of a battery system according to an embodiment of the present disclosure.

Referring to FIG. 1, a battery system according to an embodiment of the present disclosure may include a battery 10 and a battery management system 20.

The battery 10 may be a secondary battery capable of supplying power and being rechargeable and dischargeable. The battery 10 may include a plurality of battery cells Cell₁ to Cellₙ that are electrically connected in series and/or parallel. Although FIG. 1 illustrates the plurality of battery cells connected in series to form one battery 10, the configuration and structure included in the battery 10 are not limited thereto. For example, the battery 10 may include a plurality of battery modules including the plurality of battery cells connected in series. At this time, the number of battery modules and battery cells included in the battery 10 may be determined in various ways depending on the selection.

The battery management system (BMS) 20 may be electrically connected to the battery 10 to monitor and control the battery 10. For example, the BMS 20 may measure or predict the status of the plurality of battery cells included in the battery 10 to obtain status information on the plurality of battery cells, and may control the plurality of battery cells using the status information on the plurality of battery cells. The BMS 20 may include a BMIC 100 and an MCU 200.

The BMIC 100 may measure the voltage, temperature, current, etc. of the plurality of battery cells, and may transmit the status information of the measured plurality of battery cells to the MCU 200.

The BMIC 100 may be electrically connected to the plurality of battery cells included in the battery 10. For example, as shown in FIG. 1, the BMIC 100 may be electrically connected to the positive terminals of all battery cells Cell₁ to Cellₙ from the first battery cell Cell₁ to an n-th battery cell Cellₙ and the negative terminal of the n-th battery cell Cellₙ. The BMIC 100 may receive the positive electrode potential and negative electrode potential of each of the plurality of battery cells included in the battery 10, and may measure the cell voltage of each of the plurality of battery cells by calculating the difference between the positive electrode potential and the negative electrode potential of each of the plurality of battery cells.

The BMIC 100 may receive a signal for controlling cell balancing from the MCU 200 and may control cell balancing for the plurality of battery cells. Here, cell balancing refers to the process of controlling the plurality of battery cells to maintain the same voltage and state of charge (SOC).

The BMIC 100 may include a terminal N through which the cell balancing current for cell balancing flows when cell balancing is performed on the plurality of battery cells. For example, as shown in FIG. 1, when cell balancing is performed on at least one battery cell among the plurality of battery cells in the BMIC 100, the cell balancing current for cell balancing may flow to the terminal N connected to the positive electrode of the first battery cell Cell₁. At this time, a resistor R may be connected between the positive electrode of the first battery cell Cell₁ and the terminal N of the BMIC 100.

According to embodiments, the BMIC 100 may include a cell voltage measurement part 110, a cell balancing circuit 120, and a COV and CUV controller 130.

The cell voltage measurement part 110 is connected to both ends of each of the plurality of cell voltages of each of the plurality of battery cells, and may measure the plurality of cell voltages during each cell voltage measurement cycle. According to embodiments, the cell voltage measurement part 110 may measure each of the plurality of cell voltages of each of the plurality of battery cells during each cell voltage measurement cycle when cell balancing is performed on the plurality of battery cells. The cell voltage measurement part 110 may transmit the measured plurality of cell voltages to the COV and CUV controller 130 and the MCU 200 during each cell voltage measurement cycle.

The cell balancing circuit 120 may receive a signal for controlling cell balancing from the MCU 200. The cell balancing circuit 120 may perform, maintain, and end cell balancing in response to control signals received from the MCU 200.

When cell balancing is performed on at least one battery cell among the plurality of battery cells in the cell balancing circuit 120, the cell balancing current for cell balancing may flow to a specific terminal N of the BMIC 100.

At this time, the BMIC 100 consumes the current of the battery cell including the positive electrode connected to the terminal N through which the cell balancing current flows. Accordingly, errors occur in the cell voltage measurement of the battery cell including a positive electrode connected to the terminal N through which the cell balancing current flows. Meanwhile, cell balancing control of the MCU 200 is performed based on the cell voltage measured in the BMIC 100. Therefore, for accurate cell balancing control, it is necessary to compensate for the cell voltage of the battery cell including a positive electrode connected to the terminal N through which the cell balancing current flows. Regarding correction of the cell voltage of the battery cell including a positive electrode connected to the terminal N through which the cell balancing current flows, the configuration of a cell voltage corrector 210 of the MCU 200 will be described in detail below.

The COV and CUV controller 130 may perform charge over voltage (COV) control when the voltage of one or more battery cells among a plurality of battery cells exceeds a predetermined maximum allowable voltage. For example, the COV and CUV controller 130 may control charging and discharging of the plurality of battery cells to be temporarily interrupted when the voltage of any one of the plurality of battery cells exceeds a predetermined maximum allowable voltage. This allows the COV and CUV controller 130 to prevent the battery 10 from overcharging.

The COV and CUV controller 130 may perform charge under voltage (CUV) control when the voltage of one or more battery cells among the plurality of battery cells becomes lower than a predetermined minimum allowable voltage. For example, the COV and CUV controller 130 may control charging and discharging of the plurality of battery cells to be temporarily interrupted when the voltage of any one of the plurality of battery cells becomes lower than a predetermined minimum allowable voltage. This allows the COV and CUV controller 130 to prevent the battery 10 from overdischarging.

Since the COV control or CUV control of the COV and CUV controller 130 temporarily interrupts charging and discharging of the plurality of battery cells, the cell balancing being performed in the cell balancing circuit 120 may be temporarily interrupted by the COV control or CUV control. The interruption of cell balancing by the COV and CUV controller 130 is executed with priority over a cell balancing control signal that the cell balancing circuit 120 receives from the MCU 200, and is executed regardless of the control of the MCU 200. Therefore, the MCU 200 cannot know whether the cell balancing of the cell balancing circuit 120 is interrupted by the COV control or CUV control of the COV and CUV controller 130.

The MCU 200 may control the charging and discharging of the battery 10 based on the status information of the plurality of battery cells received from the BMIC 100, and may execute a control algorithm to optimize the performance of the battery 10.

According to embodiments, the MCU 200 may include the cell voltage corrector 210 and a cell balancing controller 220.

The cell voltage corrector 210 may receive each of the plurality of cell voltages of each of the plurality of battery cells from the BMIC 100 during each cell voltage measurement cycle.

The cell voltage corrector 210 may correct the cell voltage of the first battery cell Cell₁ among the plurality of cell voltages. Here, the first battery cell Cell₁ refers to a battery cell including a positive electrode connected to the terminal N through which the cell balancing current of the BMIC 100 flows.

The cell voltage of the first battery cell Cell₁ is corrected in the cell voltage corrector 210 because when cell balancing is performed on at least one battery cell among the plurality of battery cells by the cell balancing circuit 120, the current of the first battery cell Cell₁ including the positive electrode connected to the terminal N through which the cell balancing current flows in the BMIC 100 is consumed, and as a result, a voltage drop phenomenon occurs in the cell voltage of the first battery cell Cell₁.

The cell voltage corrector 210 may correct the cell voltage of the first battery cell Cell₁ by adding a predetermined correction value to the cell voltage of the first battery cell Cell₁. According to embodiments, the cell voltage corrector 210 may generate a first cell voltage of the first battery cell Cell₁ by adding a predetermined correction value to the cell voltage of the first battery cell Cell₁. At this time, the first cell voltage means the value obtained by adding a predetermined correction value to the cell voltage of the first battery cell Cell₁ during the current cell voltage measurement cycle.

Here, the correction value may be calculated by multiplying the number of battery cells among the plurality of battery cells on which cell balancing is being performed, the size of the resistance R connected between the terminal N of the BMIC 100 and the first battery cell Cell₁, and the amount of current consumed in the first battery cell Cell₁ when cell balancing is performed on one battery cell. At this time, the size of the resistance R connected between the terminal N of the BMIC 100 used to calculate the correction value and the first battery cell Cell₁, and the amount of current consumed by the first battery cell Cell₁ when performing a cell balancing operation for one battery cell, may be set differently depending on the characteristics of the BMIC 100, and may be set at the time of designing the BMS 20 and stored in a memory (not shown in the drawing) of the MCU 200.

For example, in the battery system of FIG. 1, if cell balancing is being performed on the first battery cell Cell₁, a second battery cell Cell₂, and the n-th battery cell Cellₙ among the plurality of battery cells Cell₁ to Cellₙ, and the resistance R connected between the positive electrode and the terminal N of the first battery cell Cell₁ is 2 kΩ, and the amount of current consumed by the BMIC when performing the cell balancing operation on one battery cell is 35 µA, then in the example above, the correction value may be calculated as 0.21 V, which is the product of the number of battery cells (3) on which cell balancing is being performed, the size of the resistance (2 kΩ), and the amount of current consumed per battery cell (35 µA).

The cell voltage corrector 210 may determine whether correction is necessary for the cell voltage of the first battery cell Cell₁ based on the change in the size of the cell voltage of the first battery cell Cell₁. At this time, the cell voltage corrector 210 may calculate the change in the size of the cell voltage of the first battery cell Cell₁ by comparing the cell voltage of the first battery cell Cell₁ during the current cell voltage measurement cycle with the cell voltage during the previous cell voltage measurement cycle.

The cell voltage corrector 210 determines whether correction is necessary for the cell voltage of the first battery cell Cell₁ because when COV control or CUV control is performed by the COV and CUV controller 130, the cell balancing being performed by the cell balancing circuit 120 is temporarily interrupted. When cell balancing is temporarily interrupted by COV control or CUV control, current consumption of the first battery cell Cell₁ by the BMIC 100 is also temporarily interrupted, and the voltage drop phenomenon occurring in the cell voltage of the first battery cell Cell₁ also does not occur for a while, so there is no need to correct measurement errors caused by the voltage drop in the cell voltage of the first battery cell Cell₁ occurring during cell balancing.

On the other hand, the change in cell voltage of the first battery cell Cell₁ due to the interruption or resumption of cell balancing by COV control or CUV control changes rapidly in a relatively short period of time, and is therefore distinct from the change in cell voltage of the first battery cell Cell₁ that occurs during cell balancing, which changes slowly over a relatively long period of time. Accordingly, when the cell balancing being performed in the cell balancing circuit 120 by the COV and CUV controller 130 is temporarily interrupted, the correction of the cell voltage of the first battery cell Cell₁ by the cell voltage corrector 210 is no longer necessary, so the cell voltage corrector 210 may determine whether correction of the cell voltage of the first battery cell Cell₁ is necessary based on the change in the size of the cell voltage of the first battery cell Cell₁.

According to embodiments, the cell voltage corrector 210 may determine whether correction is necessary for the cell voltage of the first battery cell Cell₁ based on the difference between the cell voltage during the current cell voltage measurement cycle and the cell voltage during the previous cell voltage measurement cycle of the first battery cell Cell₁. This is because when COV control or CUV control by the COV and CUV controller 130 starts, cell balancing is temporarily interrupted and the size of the cell voltage of the first battery cell Cell₁ increases momentarily.

For example, the cell voltage corrector 210 may determine that correction of the cell voltage of the first battery cell Cell₁ is not necessary if the difference between the cell voltage during the current cell voltage measurement cycle and the cell voltage during the previous cell voltage measurement cycle of the first battery cell Cell₁ is greater than or equal to a predetermined correction value. At this time, the cell voltage corrector 210 may transmit the cell voltage of the first battery cell Cell₁ during the current cell voltage measurement cycle and each of the plurality of cell voltages of each of the remaining plurality of battery cells to the cell balancing controller 220 without correction to the cell voltage of the first battery cell Cell₁ during the current cell voltage measurement cycle.

As another example, the cell voltage corrector 210 may determine that correction is necessary for the cell voltage of the first battery cell Cell₁ when the difference between the cell voltage during the current cell voltage measurement cycle and the cell voltage during the previous cell voltage measurement cycle of the first battery cell Cell₁ is less than a predetermined correction value. At this time, the cell voltage corrector 210 may add a predetermined correction value to the cell voltage of the first battery cell Cell₁ during the current cell voltage measurement cycle to generate the first cell voltage of the first battery cell Cell₁, and may transmit the first cell voltage and each of the plurality of cell voltages of the remaining plurality of battery cells to the cell balancing controller 220.

According to embodiments, the cell voltage corrector 210 may determine whether correction is necessary for the cell voltage of the first battery cell Cell₁ based on the difference between the cell voltage during the previous cell voltage measurement cycle and the cell voltage during the current cell voltage measurement cycle of the first battery cell Cell₁. This is because when the COV control or CUV control by the COV and CUV controller 130 is interrupted, cell balancing is restarted and the size of the cell voltage of the first battery cell Cell₁ is momentarily reduced.

For example, the cell voltage corrector 210 may determine that correction is necessary for the cell voltage of the first battery cell Cell₁ when the difference between the cell voltage during the previous cell voltage measurement cycle and the cell voltage during the current cell voltage measurement cycle of the first battery cell Cell₁ is greater than or equal to a predetermined correction value. At this time, the cell voltage corrector 210 may add a predetermined correction value to the cell voltage of the first battery cell Cell₁ during the current cell voltage measurement cycle to generate the first cell voltage of the first battery cell Cell₁, and may transmit the first cell voltage and each of the plurality of cell voltages of the remaining plurality of battery cells to the cell balancing controller 220.

As another example, the cell voltage corrector 210 may determine that correction to the cell voltage of the first battery cell Cell₁ is not necessary when the difference between the cell voltage during the previous cell voltage measurement cycle and the cell voltage during the current cell voltage measurement cycle of the first battery cell Cell₁ is less than a predetermined correction value. At this time, the cell voltage corrector 210 may transmit the cell voltage of the first battery cell Cell₁ during the current cell voltage measurement cycle and each of the plurality of cell voltages of each of the remaining plurality of battery cells to the cell balancing controller 220 without correction to the cell voltage of the first battery cell Cell₁ during the current cell voltage measurement cycle.

The cell balancing controller 220 may receive the cell voltage of the first battery cell Cell₁ and each of the plurality of cell voltages of the remaining plurality of battery cells from the cell voltage corrector 210. At this time, the cell voltage of the first battery cell Cell₁ received by the cell balancing controller 220 from the cell voltage corrector 210 may be the cell voltage of the first battery cell Cell₁ during the current cell voltage measurement cycle or may be the first cell voltage generated by adding a predetermined correction value to the cell voltage during the current cell voltage measurement cycle.

The cell balancing controller 220 may determine whether to end cell balancing for the plurality of battery cells based on the cell voltage of the first battery cell Cell₁ and each of the plurality of cell voltages of the remaining plurality of battery cells.

The cell balancing controller 220 may generate a control signal for maintaining cell balancing or a control signal for ending cell balancing and transmit it to the BMIC 100 based on the result of determining whether to end cell balancing for the plurality of battery cells.

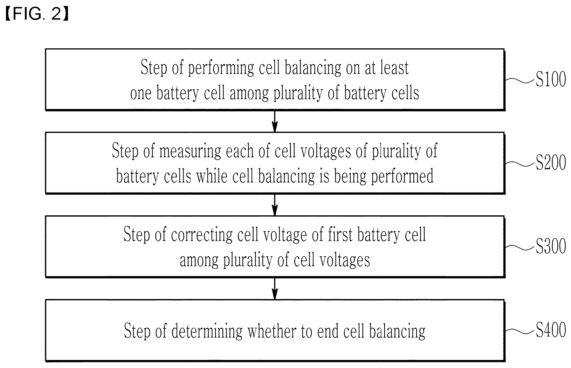

FIG. 2 is a flowchart of a method for measuring battery cell voltage according to an embodiment of the present disclosure.

Referring to FIG. 2, the method for measuring battery cell voltage according to an embodiment of the present disclosure may include a step of performing cell balancing (S100), a step of measuring cell voltage (S200), a step of correcting cell voltage of the first battery cell (S300), and a step of determining whether to end cell balancing (S400).

In the step of performing cell balancing (S100), the BMIC 100 may perform cell balancing on at least one battery cell among the plurality of battery cells included in the battery 10.

In the step of measuring cell voltage (S200), the BMIC 100 may measure each of the cell voltages of each of the plurality of battery cells while cell balancing is being performed. At this time, the cell voltage measurement part 110 of the BMIC 100 may transmit each of the plurality of cell voltages to the COV and CUV controller 130 and the MCU 200.

In the step of correcting cell voltage of the first battery cell (S300), the MCU 200 may correct the cell voltage of the first battery cell Cell₁ among the plurality of cell voltages. At this time, the MCU 200 may correct the cell voltage of the first battery cell Cell₁ including the positive electrode connected to the terminal N through which the cell balancing current included in the BMIC 100 flows by adding a predetermined correction value.

In the step of determining whether to end cell balancing (S400), the MCU 200 may determine whether to end cell balancing based on the cell voltage of the first battery cell Cell₁ and each of the plurality of cell voltages of the remaining plurality of battery cells.

According to embodiments, the MCU 200 may determine whether the cell balancing being performed in the BMIC 100 is sufficient based on the cell voltage of the corrected first battery cell Cell₁ and the remaining second cell voltage. When it is determined that cell balancing has been sufficiently performed, the MCU 200 may generate a control signal to end cell balancing and transmit it to the BMIC 100, and when it is determined that cell balancing has not been sufficiently performed, the MCU 200 may generate a control signal to maintain cell balancing and transmit it to the BMIC 100. At this time, the BMIC 100 may end or maintain cell balancing in response to the control signal of the MCU 200.

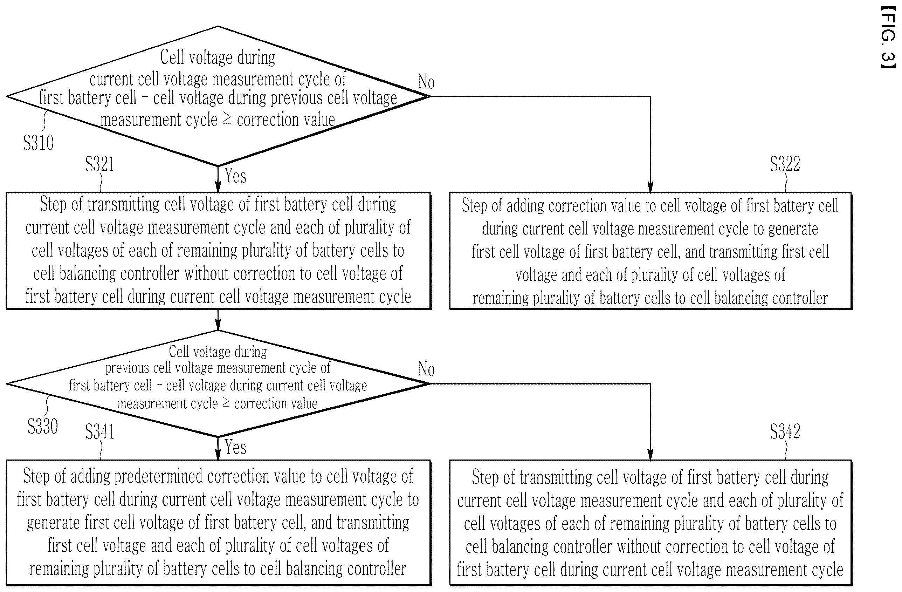

FIG. 3 is a flowchart of the step of correcting cell voltage of the first battery cell (S300) according to an embodiment of the present disclosure.

Referring to FIG. 3, in the step of correcting cell voltage of the first battery cell (S300) according to an embodiment of the present disclosure, the MCU 200 may determine whether correction is necessary for the cell voltage of the first battery cell Cell₁ based on the change in the size of the cell voltage of the first battery cell Cell₁.

In the step of correcting cell voltage of the first battery cell (S300), the cell voltage corrector 210 of the MCU 200 may determine whether correction is necessary for the cell voltage of the first battery cell Cell₁ based on the difference between the cell voltage in the current cell voltage measurement cycle and the cell voltage in the previous cell voltage measurement cycle of the first battery cell Cell₁ (S310, S321, and S322).

According to embodiments, in the step of correcting cell voltage of the first battery cell (S300), the cell voltage corrector 210 may determine whether the difference between the cell voltage during the current cell voltage measurement cycle and the cell voltage during the previous cell voltage measurement cycle of the first battery cell Cell₁ is equal to or greater than a predetermined correction value (S310).

According to embodiments, in the step of correcting cell voltage of the first battery cell (S300), if the difference between the cell voltage during the current cell voltage measurement cycle and the cell voltage during the previous cell voltage measurement cycle of the first battery cell Cell₁ is equal to or greater than a predetermined correction value (S310, Y), the cell voltage corrector 210 may transmit the cell voltage of the first battery cell Cell₁ during the current cell voltage measurement cycle and each of the plurality of cell voltages of each of the remaining plurality of battery cells to the cell balancing controller 220 of the MCU 200 without correction to the cell voltage of the first battery cell Cell₁ during the current cell voltage measurement cycle (S321). At this time, the cell balancing controller 220 may determine whether to end cell balancing based on the cell voltage of the first battery cell Cell₁ during the current cell voltage measurement cycle and each of the plurality of cell voltages of each of the remaining plurality of battery cells.

According to embodiments, in the step of correcting cell voltage of the first battery cell (S300), if the difference between the cell voltage during the current cell voltage measurement cycle and the cell voltage during the previous cell voltage measurement cycle of the first battery cell Cell₁ is less than a predetermined correction value (S310, N), the cell voltage corrector 210 may add a predetermined correction value to the cell voltage of the first battery cell Cell₁ during the current cell voltage measurement cycle to generate the first cell voltage of the first battery cell Cell₁, and may transmit the first cell voltage and each of the plurality of cell voltages of the remaining plurality of battery cells to the cell balancing controller 220 (S322). At this time, the cell balancing controller 220 may determine whether to end cell balancing based on the first cell voltage and each of the plurality of cell voltages of the remaining plurality of battery cells.

In the step of correcting cell voltage of the first battery cell (S300), the cell voltage corrector 210 of the MCU 200 may determine whether correction is necessary for the cell voltage of the first battery cell Cell₁ based on the difference between the cell voltage during the previous cell voltage measurement cycle and the cell voltage during the current cell voltage measurement cycle of the first battery cell Cell₁ (S330, S341, and S342).

According to embodiments, in the step of correcting cell voltage of the first battery cell (S300), the cell voltage corrector 210 may determine whether the difference between the cell voltage during the previous cell voltage measurement cycle and the cell voltage during the current cell voltage measurement cycle of the first battery cell Cell₁ is equal to or greater than a predetermined correction value (S330).

According to embodiments, in the step of correcting cell voltage of the first battery cell (S300), when the difference between the cell voltage during the previous cell voltage measurement cycle and the cell voltage during the current cell voltage measurement cycle of the first battery cell Cell₁ is greater than or equal to a predetermined correction value (S330, Y), the cell voltage corrector 210 may add a predetermined correction value to the cell voltage of the first battery cell Cell₁ during the current cell voltage measurement cycle to generate the first cell voltage of the first battery cell Cell₁, and may transmit the first cell voltage and each of the plurality of cell voltages of the remaining plurality of battery cells to the cell balancing controller 220 (S341). At this time, the cell balancing controller 220 may determine whether to end cell balancing based on the first cell voltage and each of the plurality of cell voltages of the remaining plurality of battery cells.

According to the embodiments, in the step of correcting cell voltage of the first battery cell (S300), when the difference between the cell voltage during the previous cell voltage measurement cycle and the cell voltage during the current cell voltage measurement cycle of the first battery cell Cell₁ is less than a predetermined correction value (S330, N), the cell voltage corrector 210 may transmit the cell voltage of the first battery cell Cell₁ during the current cell voltage measurement cycle and each of the plurality of cell voltages of each of the remaining plurality of battery cells to the cell balancing controller 220 without correction to the cell voltage of the first battery cell Cell₁ during the current cell voltage measurement cycle (S342). At this time, the cell balancing controller 220 may determine whether to end cell balancing based on the cell voltage of the first battery cell Cell₁ during the current cell voltage measurement cycle and each of the plurality of cell voltages of each of the remaining plurality of battery cells.

According to the embodiments, the step of correcting the cell voltage of the first battery cell (S300) may be repeatedly performed until cell balancing is ended in the step of determining whether to end cell balancing (S400).

Meanwhile, the above-described method may be written with a program that can be executed on a computer, and may be implemented on a general-purpose digital computer that operates the program using computer-readable recording media. The computer-readable recording media may include a storage medium such as a magnetic storage medium such as a ROM, a RAM, a USB, a floppy disk, a hard disk, or an optical readable medium such as a CD-ROM or a DVD.

The scope of the present disclosure is defined by the following claims rather than by the detailed description of the embodiments, and it should be understood that all modifications and embodiments conceived from the meaning and scope of the claims and their equivalents are included in the scope of the present disclosure.

## Claims

1. A battery system, comprising:
a plurality of battery cells electrically connected;
a BMIC comprising a terminal through which a cell balancing current for cell balancing flows and connected to both ends of each of the plurality of battery cells to measure each of the plurality of cell voltages during each cell voltage measurement cycle when the cell balancing is performed on the plurality of battery cells; and
an MCU configured to determine whether to end the cell balancing based on the cell voltage of a first battery cell during the current cell voltage measurement cycle and each of the plurality of cell voltages of each of the remaining plurality of battery cells when the difference between the cell voltage of the first battery cell including a positive electrode connected to the terminal during the current cell voltage measurement cycle and the cell voltage during the previous cell voltage measurement cycle among the plurality of cell voltages is greater than or equal to a predetermined correction value.

2. The battery system of claim 1, wherein
the correction value is
calculated by multiplying the number of battery cells among the plurality of battery cells on which the cell balancing is being performed, the size of the resistance connected between the terminal and the first battery cell, and the amount of current consumed by the first battery cell when the cell balancing is performed for one battery cell.

3. The battery system of claim 1, wherein
the MCU comprises
a cell voltage corrector configured to receive each of the plurality of cell voltages from the BMIC during each cell voltage measurement cycle and determine whether correction is required for the cell voltage of the first battery cell based on a change in a magnitude of the cell voltage of the first battery cell; and
a cell balancing controller configured to generate a control signal for terminating the cell balancing and transmit the control signal to the BMIC based on a determination of whether to end the cell balancing.

4. The battery system of claim 1, wherein
the MCU is configured to,
when the difference between the cell voltage during the current cell voltage measurement cycle and the cell voltage during the previous cell voltage measurement cycle of the first battery cell is less than the correction value,
add the correction value to the cell voltage of the first battery cell during the current cell voltage measurement cycle to generate a first cell voltage of the first battery cell, and
determine whether to end the cell balancing based on the first cell voltage and each of the plurality of cell voltages of each of the remaining plurality of battery cells.

5. The battery system of claim 1, wherein
the MCU is configured to,
when the difference between the cell voltage of the first battery cell during the previous cell voltage measurement cycle and the cell voltage during the current cell voltage measurement cycle is greater than or equal to the correction value,
add the correction value to the cell voltage of the first battery cell during the current cell voltage measurement cycle to generate the first cell voltage of the first battery cell, and
determine whether to end the cell balancing based on the first cell voltage and each of the plurality of cell voltages of each of the remaining plurality of battery cells.

6. The battery system of claim 1, wherein
the MCU is configured to,
when the difference between the cell voltage of the first battery cell during the previous cell voltage measurement cycle and the cell voltage during the current cell voltage measurement cycle is less than the correction value,
determine whether to end the cell balancing based on the cell voltage of the first battery cell during the current cell voltage measurement cycle and each of the plurality of cell voltages of each of the remaining plurality of battery cells.

7. A method for measuring battery cell voltage, comprising:
performing, by a BMIC, cell balancing on at least one battery cell among a plurality of battery cells included in a battery;
measuring, by the BMIC, each of a plurality of cell voltages of each of the plurality of battery cells while the cell balancing is performed;
correcting, by an MCU, the cell voltage of a first battery cell by adding a predetermined correction value to the cell voltage of the first battery cell, which includes a positive electrode connected to a terminal through which a cell balancing current flows in the BMIC, among the plurality of cell voltages received from the BMIC; and
determining, by the MCU, whether to end the cell balancing based on the cell voltage of the first battery cell that has been corrected and each of the plurality of cell voltages of the remaining plurality of battery cells.

8. The method for measuring the battery cell voltage of claim 7, wherein
the correcting of the cell voltage of the first battery cell comprises
when the difference between the cell voltage during the current cell voltage measurement cycle and the cell voltage during the previous cell voltage measurement cycle of the first battery cell is greater than or equal to the correction value, transmitting, by a cell voltage corrector of the MCU, the cell voltage of the first battery cell during the current cell voltage measurement cycle and each of the cell voltages of each of the remaining plurality of battery cells to a cell balancing controller of the MCU, without correcting the cell voltage of the first battery cell during the current cell voltage measurement cycle; and
when the difference between the cell voltage during the current cell voltage measurement cycle and the cell voltage during the previous cell voltage measurement cycle of the first battery cell is less than the correction value, generating, by the cell voltage corrector of the MCU, a first cell voltage of the first battery cell by adding the correction value to the cell voltage of the first battery cell during the current cell voltage measurement cycle, and transmitting the first cell voltage and each of the plurality of cell voltages of the remaining plurality of battery cells to the cell balancing controller.

9. The method for measuring the battery cell voltage of claim 8, wherein
the transmitting of the cell voltage of the first battery cell during the current cell voltage measurement cycle and each of the cell voltages of each of the remaining plurality of battery cells to the cell balancing controller of the MCU comprises
when the difference between the cell voltage during the previous cell voltage measurement cycle and the cell voltage during the current cell voltage measurement cycle of the first battery cell is greater than or equal to the correction value, the cell voltage corrector generating the first cell voltage of the first battery cell by adding the correction value to the cell voltage of the first battery cell during the current cell voltage measurement cycle, and transmitting the first cell voltage and each of the plurality of cell voltages of the remaining plurality of battery cells to the cell balancing controller; and
when the difference between the cell voltage of the first battery cell during the previous cell voltage measurement cycle and the cell voltage during the current cell voltage measurement cycle is less than the correction value, transmitting the cell voltage of the first battery cell during the current cell voltage measurement cycle and each of the cell voltages of each of the remaining plurality of battery cells to a cell balancing controller of the MCU, without correcting the cell voltage of the first battery cell during the current cell voltage measurement cycle.

10. The method for measuring the battery cell voltage of claim 8, wherein
the determining of whether to end the cell balancing comprises
in the correcting of the cell voltage of the first battery cell, when the difference between the cell voltage during the current cell voltage measurement cycle and the cell voltage during the previous cell voltage measurement cycle of the first battery cell is greater than or equal to the correction value, determining whether to end the cell balancing based on the cell voltage of the first battery cell during the current cell voltage measurement cycle and each of the plurality of cell voltages of each of the remaining plurality of battery cells; and
in the correcting of the cell voltage of the first battery cell, when the difference between the cell voltage during the current cell voltage measurement cycle and the cell voltage during the previous cell voltage measurement cycle of the first battery cell is less than the correction value, determining whether to end the cell balancing based on the first cell voltage and each of the plurality of cell voltages of each of the remaining plurality of battery cells.
